# EUROPEAN PATENT SPECIFICATION

(11) **EP 1 659 844 B1**
(45) Date of publication and mention of the grant of the patent: **22.10.2008**
(21) Application number: 04388078.0
(22) Date of filing: 19.11.2004
(51) Int. Cl.: H05K 9/00

(54) **An electromagnetic shield for shielding electrical components on a printed circuit board**
Elektromagnetische Abschirmung für elektrische Bauteile auf einer gedrucken Leiterplatte
Blindage électromagnétique pour le blindage de composants électriques sur une plaque à circuit imprimé

(43) Date of publication of application: 24.05.2006
(73) Proprietor: Sony Ericsson Mobile Communications AB, 221 88 Lund (SE)
(72) Inventor: Fagrenius, Gustav, 2410 Dalby (SE)
(74) Representative: Boesen, Johnny Peder

(56) References cited:
- DE-A1- 19 932 419
- DE-U1- 9 404 817
- US-A- 5 633 786
- US-A- 5 917 708

## Description

### Field of the invention

The invention relates to shielding of electrical and electronic components on a printed circuit board against electromagnetic interference (EMI) and in particular against radio frequency interference (RFI). Without proper shielding electromagnetic and radio frequency signals from outside can interfere with the circuits on the printed circuit board and disturb their proper functioning, and such signals in the circuits can interfere with sensitive circuits in the neighborhood. To avoid such electromagnetic interference relevant components on the printed circuit board are encapsulated in an electrically conducting enclosure, which provides the necessary shielding.

### Background of the invention

In order to shield electronic components, in for example mobile phones, some kind of electrically conductive box or can is normally placed on the printed circuit board (PCB) with the circuits to be shielded inside the box. The highest level of shielding is probably reached by soldering metal cans to the PCB. A critical demand that has to be fulfilled to achieve good shielding is that the solder joint has to be well controlled and without any unsoldered areas or discontinuities.

The first step in the soldering process is to screen-print the PCB with solder paste. The thickness of the solder paste is determined by the thickness of the screen-printing stencil. In the next step the components are put on the board by a pick-and-place machine. Shield cans are normally placed on the board after the components to be shielded since it is mounted on top of them. In the last step of the process the PCB is taken through a soldering oven.

Neither the metal cans nor the PCBs can be manufactured perfectly flat, and the flatness is also likely to be affected by the heat in the soldering oven. This means that there will always be a gap between the shield can and the PCB. This is no problem as long as the gap is filled with solder material. However, the thickness of the solder paste is limited, which means that the size of an acceptable gap between the shield can and the PCB also is limited. Soldered shield cans are made small in order to be properly soldered. Since the width of the gap is getting larger when the size of the shield can increases there is a limit to the size of the shield can. Therefore, only relatively small shield cans are used.

If large PCB areas or spaces are to be shielded extra shield cans are needed and PCB space is lost due to the necessary space between shield cans. When a shield can has to be divided into two the necessary distance between them can be several mm resulting in loss of space on the PCB.

DE 94 04 817 U1 shows an electromagnetic shielding can that is made out of one piece of sheet metal. The top wall has several holes forming a bending line. The purpose of this is to enable opening the can after it has been mounted on the PCB so that components within the can may be accessed and exchanged. This document neither addresses nor solves the problem of mechanical tolerances in large cans, which is identified in the present application.

### Summary of the invention

The invention solves this problem by dividing larger shields into two or more parts that are interconnected along a common pivot axis, and the first and second parts can pivot relative to each other about the pivot axis. Thereby each one of the parts can be kept at a size allowing proper soldering to the PCB, and there is no unused space between the parts.

The invention thus comprises an electromagnetic shield for shielding electrical components on a printed circuit board, the shield comprising a first shield part with a first peripheral wall and a second shield part with a second peripheral wall, the first and second peripheral walls both having a predetermined height and together defining a space enclosed within the first and second peripheral walls, wherein the first and second parts are interconnected along a common pivot axis, and the first and second parts can pivot relative to each other about the pivot axis.

The first part can have a wall portion along the pivot axis, and the second part can have a first and second depending tongues adapted, when the first and second parts are interconnected, to be on opposite sides of the wall portion of the first part to limit the pivot movement of the parts. Hereby, by lifting one part both parts can be lifted without being folded along their pivot axis.

The first and second tongues can be spaced apart at a distance transversely to the pivot axis corresponding to the thickness of the wall portion of the first part along the pivot axis to allow the latter to pass freely between the first and second tongues. Hereby the parts can have greater mobility relative to each other when mounted on the printed circuit board.

The wall portion of the first part along the pivot axis is preferably a strip of smaller height than the height of the walls.

Preferably, when assembled the first tongue is on the distal side of the wall portion, and the second tongue is on the proximal side of the pivot axis wall portion, and the first tongue is shorter than the second tongue. Hereby the pivoting movement is more restricted when the shield is picked by lifting the first part than when mounted on the printed circuit board.

Preferably, the shield has an open top covered by a lid.

The invention also comprises a printed circuit board with electrical components and a shield as described above with the components within the first and second peripheral walls, and an apparatus comprising such a printed circuit board.

A supply tape with a plurality of shields as described above arranged thereon for being picked from the tape and mounted on a printed circuit board, and a reel with a tape according to claim 9 coiled thereon are also comprised by the invention.

### Brief description of the drawings

Figure 1 shows an electromagnetic shield according to the invention having two parts shown separate;
Figure 2 shows a cross section of the shield in figure 1 taken at the line II-II;
Figure 3 illustrates how the parts are assembled;
Figure 4 shows the shield in figure 1 with its parts assembled;
Figure 5 shows a cross section of the shield in figure 4 taken at the line V-V, and illustrates the lifting of the assembled parts for mounting on a printed circuit board;
Figure 6 shows the shield mounted on a printed circuit board; and
Figure 7 illustrates a reel with a supply tape with a plurality of shields arranged thereon for being picked from the tape and mounted on a printed circuit board.

### Detailed description of the invention

The figures illustrate the invention schematically only, and proportions cannot be deduced from the drawings.

In the figures is shown a shield comprising a first shield part 100 and a second shield part 200. Both shield parts have an opening 101, 201 respectively in the top wall, so that each part has a frame-like structure.

For interconnecting the first and second shield parts 100, 200 the first part 100 has a wall 102 depending from the top wall. A cutout 103 in the top wall and the wall 102 leaves a strip 104 of the wall 102. The second part has two first tongues 202 and a second tongue 203 depending from the top wall.

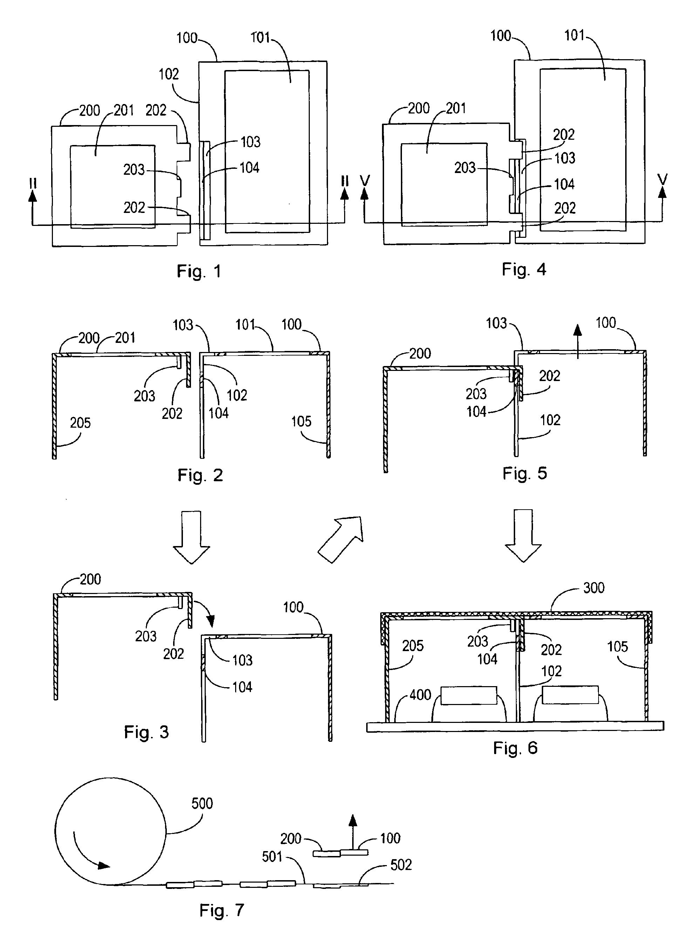

Figure 3 illustrates how the first and second shield parts 100, 200 are interconnected. The first tongues 202 are inserted into the cutout 103 to be on the inner side of the strip 104, and the second tongue 203 is on the outer side of the strip 104.

Figures 4 and 5 illustrate the first and second shield parts 100, 200 when interconnected. The first and second tongues 202, 203 are spaced apart at a distance in their longitudinal direction corresponding to the thickness of the strip 104 to allow the strip to pass freely between the first and second tongues. When the first shield part 100 is lifted as indicated by an arrow, the strip 104 will abut the horizontal portions of the first tongues 202, which are also a portion of the top wall. The second part 200 thus rides on the strip 104 and will be lifted together with the first part 100. In this relative position the first shield part 100 can pivot about a pivot axis defined by the strip 104 to a limited extent determined by the thickness of the strip 104 and the available space between the tongues.

Outside the interconnection area both of the shield parts have peripheral walls 105, 205 depending from the edges of their top walls.

The shield with its two shield parts 100 and 200 are picked e.g. from a supply tape and lifted as shown in figure 5 and placed on a printed circuit board 400 as shown in figure 6, where the lower edges of the peripheral walls rest on the printed circuit board and are soldered to the printed circuit board 400. Together the peripheral walls 102, 105, 205 define a space with the components to be shielded within the space. It is seen that the lower edge of the second tongue 203 is lower than the upper edge of the strip 104, whereby the two shield parts are free to pivot, but they are still held together by the first tongues 202 being behind the strip 104 and cooperating therewith. A lid 300 is secured to the top of the combined first and second parts, preferably snapped on, and covers the openings 101 and 201 to establish the complete shield.

The strip 104 may be a wall portion having its lower edge at the same level as the remaining lower edges of the first part, whereby total space within the shield is divided in two separate shielded spaces.

Figure 7 shows a supply reel 500 with a supply tape 501 carrying several shields having first and second shield parts as described above. The shields are arranged in pockets 502 or depressions in the surface of the tape, where each pocket is configured to hold a shield, preferably with the first part 100 at a slightly higher level than the second part 200 as in figure 5. This facilitates that e.g. a pick-and place machine can pick the shields from the tape and place them on a printed circuit board 400 as described above and as indicated in figure 7.

## Claims

1. An electromagnetic shield for shielding electrical components on a printed circuit board (400), the shield comprising a first shield part (100) with a first peripheral wall (105) and a second shield part (200) with a second peripheral wall (205), the first and second peripheral walls both having a predetermined height and together defining a space enclosed within the first and second peripheral walls (102, 105, 205),
wherein the first and second parts (100, 200) are interconnected along a common pivot axis, and the first and second parts (100, 200) can pivot relative to each other about the pivot axis,
**characterized in that**
• the first and second parts (100, 200) are separate parts arranged to be interconnected;
• the first part (100) has a wall portion (104) along the pivot axis; and
• the second part (200) has first and second depending tongues (202, 203) adapted, when the first and second parts are interconnected, to be positioned on opposite sides of the wall portion (104) of the first part (100) to limit the pivot movement of the parts.

2. A shield according to claim 1, wherein the first and second tongues (202, 203) are spaced apart at a distance transversely to the pivot axis corresponding to the thickness of the wall portion (104) of the first part along the pivot axis to allow the latter to pass freely between the first and second tongues (202, 203).

3. A shield according to claim 1 or 2, wherein the wall portion of the first part along the pivot axis is a strip (104) of smaller height than the height of the walls (102, 105, 205).

4. A shield according to any one of claims 1 to 3, wherein the first tongue (202) is on the distal side of the pivot axis wall portion (104), and the second tongue (203) is on the proximal side of the wall portion (104), and the second tongue (203) is shorter than the first tongue (202).

5. A shield according to any one of the claims 1-4 having an open top (101, 201) covered by a lid (300).

6. A printed circuit board (400) with electrical components and a shield according to any one of claims 1-5 with the components within the first and second peripheral walls (102, 105, 205).

7. An apparatus comprising a printed circuit board (400) according to claim 6.

8. A supply tape (501) with a plurality of shields according to any one of claims 1-5 each arranged in a depression (502) thereon for being picked from the tape (501) and mounted on a printed circuit board (400).

9. A reel (500) with a tape according to claim 8 coiled thereon.

## Patentansprüche

1. Elektromagnetische Abschirmung zum Abschirmen elektrischer Komponenten auf einem gedruckten Schaltungsbrett (400), wobei die Abschirmung einen ersten Abschirmteil (100) mit einer ersten Umgebungswand (105) und einen zweiten Abschirmteil (200) mit einer zweiten Umgebungswand (205) umfasst, wobei die erste und die zweite Umgebungswand beide eine vorbestimmte Höhe aufweisen und zusammen einen Raum definieren, der innerhalb der ersten und der zweiten Umgebungswand (102, 105, 205) definiert ist,
wobei der erste und der zweite Teil (100, 200) entlang einer gemeinsamen Drehachse verbunden sind und der erste und der zweite Teil (100, 200) sich bezüglich zueinander um die Drehachse drehen können,
**dadurch gekennzeichnet, dass**
- die erste und zweiten Teile (100, 200) getrennte Teile sind, die angeordnet sind, verbunden zu werden;
- der erste Teil (100) einen Wandteil (104) entlang der Drehachse aufweist; und
- der zweite Teil (200) erste und zweite abhängige Zungen (202, 203) aufweist, die angepasst sind, wenn der erste und der zweite Teil verbunden sind, an entgegen gesetzten Seiten des Wandteiles (104) des ersten Teils (100) angeordnet zu sein, um die Drehbewegung der Teile zu begrenzen.

2. Abschirmung nach Anspruch 1, wobei die erste und zweite Zunge (202, 203) bei einer Entfernung schräg zu der Drehachse entsprechend der Dicke des Wandteiles (104) des ersten Teils entlang der Drehachse räumlich getrennt sind, um es der letzteren zu erlauben, frei zwischen der ersten und zweiten Zunge (202, 203) hindurchzupassieren.

3. Abschirmung nach Anspruch 1 oder 2, wobei der Wandteil des ersten Teils entlang der Drehachse ein Streifen (104) einer kleineren Höhe als die Höhe der Wände (102, 105, 205) ist.

4. Abschirmung nach einem der Ansprüche 1 bis 3, wobei die erste Zunge (202) sich an der distalen Seite des Drehachsenwandteiles (104) befindet und sich die zweite Zunge (203) an der proximalen Seite des Wandteiles (104) befindet und die zweite Zunge (203) kürzer als die erste Zunge (204) ist.

5. Abschirmung nach einem der Ansprüche 1-4 mit einem offenen Oberteil (101, 201), das von einem Deckel (300) abgedeckt wird.

6. Gedrucktes Schaltungsbrett (400) mit elektrischen Bauteilen und einer Abschirmung nach einem der Ansprüche 1-5 mit den Bauteilen innerhalb der ersten und zweiten Umgebungswand (102, 105, 205).

7. Gerät mit einem gedruckten Schaltungsbrett (400) nach Anspruch 6.

8. Zuführband (501) mit einer Vielzahl von Abschirmungen nach einem der Ansprüche 1-5, die alle in einer Vertiefung (502) auf diesem angeordnet sind, um von dem Band (501) herausgegriffen zu werden und auf einem gedruckten Schaltungsbrett (400) montiert zu werden.

9. Walze (500) mit einem Band nach Anspruch 8, das auf diese gespult ist.

## Revendications

1. Blindage électromagnétique pour protéger des composants électriques sur une plaquette (400) à circuit imprimé, le blindage comportant une première partie de blindage (100) ayant une première paroi périphérique (105) et une seconde partie de blindage (200) ayant une seconde paroi périphérique (205), les première et seconde parois périphériques ayant toutes deux une hauteur prédéterminée et définissant ensemble un espace enfermé à l'intérieur des première et seconde parois périphériques (102, 105, 205),
dans lequel les première et seconde parties (100, 200) sont reliées entre elles le long d'un axe commun de pivotement, et les première et seconde parties (100, 200) peuvent pivoter l'une par rapport à l'autre autour de l'axe de pivotement,
**caractérisé en ce que**
• les première et seconde parties (100, 200) sont des parties séparées agencées de façon à être reliées entre elles ;
• la première partie (100) comporte une partie de paroi (104) le long de l'axe de pivotement ; et
• la seconde partie (200) comporte des première et seconde languettes (202, 203) tournées vers le bas et conçues, lorsque les première et seconde parties sont reliées entre elles, pour être positionnées sur des côtés opposés de la partie de paroi (104) de la première partie (100) afin de limiter le mouvement de pivotement des parties.

2. Blindage selon la revendication 1, dans lequel les première et seconde languettes (202, 203) sont espacées d'une distance transversale à l'axe de pivotement, correspondant à l'épaisseur de la partie de paroi (104) de la première partie le long de l'axe de pivotement afin de permettre à ce dernier de passer librement entre les première et seconde languettes (202, 203).

3. Blindage selon la revendication 1 ou 2, dans lequel la partie de paroi de la première partie le long de l'axe de pivotement est une bande (104) d'une hauteur inférieure à la hauteur des parois (102, 105, 205).

4. Blindage selon l'une quelconque des revendications 1 à 3, dans lequel la première languette (202) est située sur le côté distal de la partie de paroi (104) de l'axe de pivotement, et la seconde languette (203) est située sur le côté proximal de la partie de paroi (104), et la seconde languette (203) est plus courte que la première languette (202).

5. Blindage selon l'une quelconque des revendications 1 à 4, ayant un dessus ouvert (101, 201) recouvert par un couvercle (300).

6. Plaquette (400) à circuit imprimé ayant des composants électriques et un blindage selon l'une quelconque des revendications 1 à 5, les composants étant à l'intérieur des première et seconde parois périphériques (102, 105, 205).

7. Appareil comportant une plaquette (400) à circuit imprimé selon la revendication 6.

8. Bande d'alimentation (501) pourvue de multiples blindages selon l'une quelconque des revendications 1 à 5, agencés chacun dans un creux (502) sur cette bande pour être pris depuis la bande (501) et montés sur une plaquette (500) à circuit imprimé.

9. Bobine (500) sur laquelle une bande selon la revendication 8 est enroulée.
